# EUROPEAN PATENT APPLICATION

(11) **EP 1 780 790 A2**
(43) Date of publication of application: **02.05.2007**
(21) Application number: 06022502.6
(22) Date of filing: 27.10.2006
(51) Int. Cl.: H01L 23/498, H01L 25/065, H01L 23/538

(54) **Electronic part built-in substrate and manufacturing method therefor**

(30) Priority: 27.10.2005 JP 2005313243
(71) Applicant: SHINKO ELECTRIC INDUSTRIES CO., LTD., Nagano-shi, Nagano 381-2287 (JP)
(72) Inventor: Machida, Yoshihiro, Nagano-shi Nagano, 381-2287 (JP)
(74) Representative: Zimmermann & Partner

(57) **Abstract**

The electronic-part built-in substrate includes a coreless substrate 11 in which a wiring pattern 31 is formed in laminated insulating layers 26 and 27, a semiconductor chip 14 electrically connected to the wiring pattern 31, a resin layer 13 configured to cover a first main surface of the coreless substrate 11 and to have an accommodating portion 57 that accommodates the semiconductor chip 14, and a sealing resin 19 that seals the semiconductor chip 14 accommodated in the accommodating portion 57.

## Description

The present disclosure relates to an electronic part built-in substrate, or to a substrate with a built-in electronic part. In particular, the present disclosure relates to an electronic part built-in substrate having a multilayer wiring structure and, more particularly, an electronic part electrically connected to a wiring pattern provided in the multilayer wiring structure.

In recent years, significant progress has been made in high densification of electronic part, such as semiconductor chips, to thereby achieve the miniaturization thereof. Along with this, an electronic part built-in substrate has been proposed, which incorporates electronic part in a multilayer wiring structure configured so that a wiring pattern is formed in a plurality of laminated insulating layers.

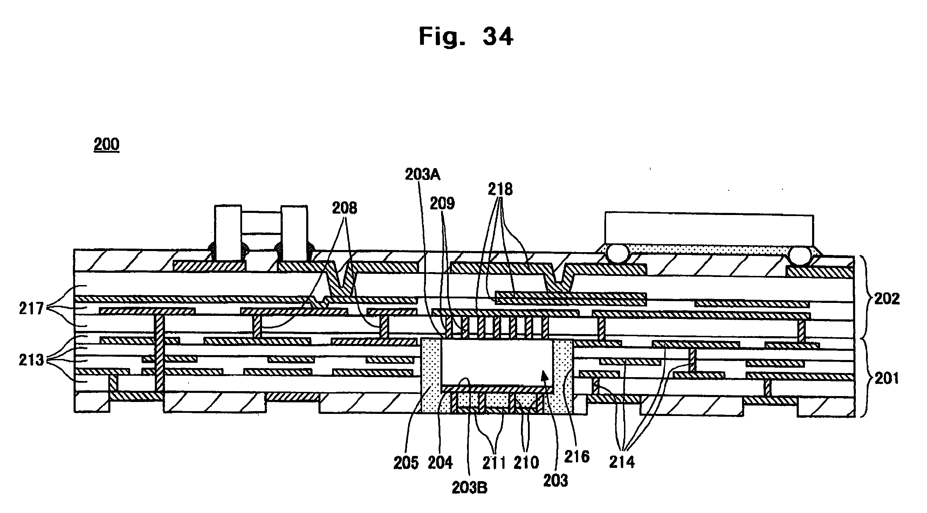

FIG. 34 is a cross-sectional view of a related electronic-part built-in substrate.

As shown in FIG. 34, an electronic-part built-in substrate 200 has a first multilayer wiring structure 201, a secondmultilayer wiring structure 202, a bare chip 203, a heat radiation plate 204, a sealing resin 205, vias 208, 209, and 210, and heat radiation terminals 211.

The first multilayer wiring structure 201 has a laminated resin layer 213 and a first wiring pattern 214 provided in the laminated resin layer 213. An accommodating portion 216 is formed to accommodate the bare chip 203.

The second multilayer wiring structure 202 is provided on the first multilayer wiring structure 201. The second multilayer wiring structure 202 has a laminated resin layer 217 and a second wiring pattern 218 provided in the laminated resin layer 217. The second wiring pattern 218 is electrically connected to the first wiring pattern 214 through the via 208.

The bare chip 203 is arranged in the accommodating portion 216 and is sealed with the sealing resin 205. The bare chip 203 has an electrode (not shown) connected to the via 209. This electrode is electrically connected to the second wiring pattern 218 through the via 209.

Thus, the miniaturization of the electronic-part built-in substrate 200 can be achieved by providing the bare chip 203 in the accommodating portion 216 formed in the first multilayer wiring structure 201.

The heat radiating plate 204 is provided on a surface 203B of the bare chip 203, which is opposite to a surface 203Awhere the electrode connected to the via 209 is formed. The heat radiating plate 204 is connected to the via 210. The heat radiating terminals 211 are exposed from the sealing resin 205 and are thermally connected to the heat radiating plate 204 through the via 210.

The heat radiating terminals 211 radiate heat generated in the bare chip 203 by being connected to a heat radiating member provided on a mount board, such as a heat sink, in a state where the electronic-part built-in substrate 200 is connected to the mount board such as a mother board (not shown) (See, for example, Patent Document 1: Japanese Patent Unexamined Publication No.2004-79736).

However, in the related electronic-part built-in substrate 200, the second multilayer wiring structure 202 is formed on the first multilayer wiring structure 201, after the bare chip 203 is accommodated in the accommodating portion 216 of the first multilayer wiring structure 201. Therefore, the related art has one problem that even when the bare chip 203 being KGD (Known Good Die) is mounted on the first multilayer wiring structure 201, the related electronic-part built-in substrate 200 is a defective product in a case that a failure, such as a shortcircuit, occurs in the second wiring pattern 218, so that the yield of the electronic-part built-in substrate 200 is reduced.

Additionally, for radiating heat of the bare chip 203, it is necessary to connect the heat radiating plate 204, which is provided in the bare chip 203, to the heat radiating member, such as a heat sink provided on a mount board, through the via 210 and the heat radiating terminals 211. Therefore, the related art has another problem that heat generated from the bare chip 203 cannot sufficiently be radiated.

The present invention intends to overcome at least some of the above problems. The object is solved by the electronic-part built-in substrate according to claim 1, and by the method of manufacturing such a substrate according to claim 6. Further advantages, features, aspects and details of the invention are evident from the dependent claims, the description and the drawings.

According to an aspect of one or more embodiments of the invention, there is provided an electronic-part built-in substrate comprising:
a multilayer wiring structure in which a wiring pattern is formed in laminated insulating layers;
an electronic part electrically connected to the wiring pattern;
a resin layer which covers a first main surface of the multilayer wiring structure and has an accommodating portion which accommodates the electronic-part; and
a sealing resin which seals the electronic-part accommodated in the accommodating portion.

According to the invention, it is possible that the electronic part is electrically connected to the wiring pattern of the multilayer wiring structure after the multilayer wiring structure is formed. Consequently, the yield of the electronic-part built-in substrate can be enhanced by mounting the electronic part on the multilayer wiring structure which is preliminarily determined to be a nondefective product.

Also, a heat radiating element exposed from the sealing resin may be provided on a surface of the electronic part, which is opposite to a surface thereof electrically connected to the wiring pattern. Consequently, with a simpler configuration than that of the related substrate, heat generated from the electronic part can be efficiently radiated through the heat radiating element.

Additionally, the electronic-part built-in substrate according to the invention may be provided with a through-via electrically connected to the wiring pattern and penetrating through the resin layer. Accordingly, the through-via is adapted to function as an external connecting terminal. Thus, another substrate or a semiconductor device may be connected to the through-via. Consequently, the packaging density can be enhanced. According to a further aspect, an electronic-part built-in substrate includes a coreless substrate in which a wiring pattern is formed in laminated insulating layers, a semiconductor chip electrically connected to the wiring pattern, a resin layer configured to cover a first main surface of the coreless substrate and to have an accommodating portion that accommodates the semiconductor chip, and a sealing resin that seals the semiconductor chip accommodated in the accommodating portion.

The electronic-part built-in substrate can be a substrate having a built-in electronic part. The accommodating portion may be concave.

The invention is also directed to apparatuses for carrying out the disclosed methods and including apparatus parts for performing each described method steps.

One or more of the following advantages may be present in some embodiments. For example, it is possible to enhance the yield of an electronic-part built-in substrate and to efficiently radiate heat generated from the built-in electronic part. Other features and advantages are not limited to such specific embodiments.

The invention will be better understood by reference to the following description of embodiments of the invention taken in conjunction with the accompanying drawings, wherein:
FIG. 1 is a cross-sectional view of an electronic-part built-in substrate according to an embodiment of the present invention.
FIG. 2 is a view of an example of an electronic apparatus having the electronic-part built-in substrate according to the embodiment of the present invention.
FIG. 3 is a view of another example of the electronic apparatus having the electronic-part built-in substrate according to the embodiment of the present invention.
FIG. 4 is a view showing a first process step for manufacturing an electronic-part built-in substrate according to the embodiment of the present invention.
FIG. 5 is a view showing a second process step for manufacturing the electronic-part built-in substrate according to the embodiment of the present invention.
FIG. 6 is a view showing a third process step for manufacturing the electronic-part built-in substrate according to the embodiment of the present invention.
FIG. 7 is a view showing a fourth process step for manufacturing the electronic-part built-in substrate according to the embodiment of the present invention.
FIG. 8 is a view showing a fifth process step for manufacturing the electronic-part built-in substrate according to the embodiment of the present invention.
FIG. 9 is a view showing a sixth process step for manufacturing the electronic-part built-in substrate according to the embodiment of the present invention.
FIG. 10 is a view showing a seventh process step for manufacturing the electronic-part built-in substrate according to the embodiment of the present invention.
FIG. 11 is a view showing an eighth process step for manufacturing the electronic-part built-in substrate according to the embodiment of the present invention.
FIG. 12 is a view showing a ninth process step for manufacturing the electronic-part built-in substrate according to the embodiment of the present invention.
FIG. 13 is a view showing a tenth process step for manufacturing the electronic-part built-in substrate according to the embodiment of the present invention.
FIG. 14 is a view showing an eleventh process step for manufacturing the electronic-part built-in substrate according to the embodiment of the present invention.
FIG. 15 is a view showing a twelfth process step for manufacturing the electronic-part built-in substrate according to the embodiment of the present invention.
FIG. 16 is a view showing a thirteenth process step for manufacturing the electronic-part built-in substrate according to the embodiment of the present invention.
FIG. 17 is a view showing a fourteenth process step for manufacturing the electronic-part built-in substrate according to the embodiment of the present invention.
FIG. 18 is a view showing a fifteenth process step for manufacturing the electronic-part built-in substrate according to the embodiment of the present invention.
FIG. 19 is a view showing a sixteenth process step for manufacturing the electronic-part built-in substrate according to the embodiment of the present invention.
FIG. 20 is a view showing a seventeenth process step for manufacturing the electronic-part built-in substrate according to the embodiment of the present invention.
FIG. 21 is a view showing an eighteenth process step for manufacturing the electronic-part built-in substrate according to the embodiment of the present invention.
FIG. 22 is a view showing a nineteenth process step for manufacturing the electronic-part built-in substrate according to the embodiment of the present invention.
FIG. 23 is a view showing a twentieth process step for manufacturing the electronic-part built-in substrate according to the embodiment of the present invention.
FIG. 24 is a view showing a twenty-first process step for manufacturing the electronic-part built-in substrate according to the embodiment of the present invention.
FIG. 25 is a view showing a twenty-second process step for manufacturing the electronic-part built-in substrate according to the embodiment of the present invention.
FIG. 26 is a view showing a twenty-third process step for manufacturing the electronic-part built-in substrate according to the embodiment of the present invention.
FIG. 27 is a view showing a twenty-fourth process step for manufacturing the electronic-part built-in substrate according to the embodiment of the present invention.
FIG. 28 is a view showing a twenty-fifth process step for manufacturing the electronic-part built-in substrate according to the embodiment of the present invention.
FIG. 29 is a view showing a twenty-sixth process step for manufacturing the electronic-part built-in substrate according to the embodiment of the present invention.
FIG. 30 is a view showing a twenty-seventh process step for manufacturing the electronic-part built-in substrate according to the embodiment of the present invention.
FIG. 31 is a view showing a twenty-eighth process step for manufacturing the electronic-part built-in substrate according to the embodiment of the present invention.
FIG. 32 is a view showing a twenty-ninth process step for manufacturing the electronic-part built-in substrate according to the embodiment of the present invention.
FIG. 33 is a view showing a thirtieth process step for manufacturing the electronic-part built-in substrate according to the embodiment of the present invention.
FIG. 34 is a cross-sectional view of a related electronic-part built-in substrate.

Preferred embodiments of the present invention will hereinafter be described in detail with reference to the accompanying drawings.

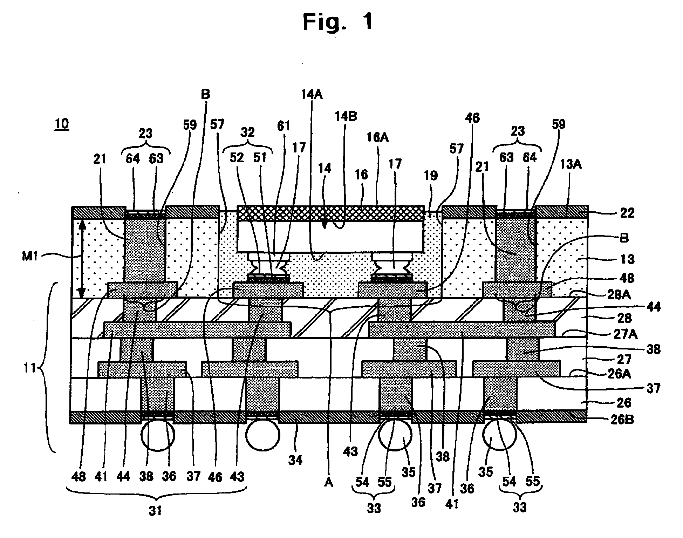

FIG. 1 is a cross-sectional view of an electronic-part built-in substrate according to the embodiment of the invention. In FIG. 1, reference character A denotes a region on a surface of the coreless substrate 11, in which a semiconductor chip 14 is connected (hereunder referred to as a "semiconductor chip connection region A"). Reference character B denotes a position where a through-via 21 is formed (hereunder referred to as a "through-via formation position B"). Reference character M1 denotes a thickness of a resin layer 13 with respect to a top surface 28A of a prepreg resin layer 28 (hereunder referred to as a "thickness M1"). Incidentally, a case where the semiconductor chip 14 is built into the electronic-part built-in substrate as an electronic part will be described below as an example of the present embodiment of the invention.

An electronic-part built-in substrate 10 according to the present embodiment of the invention will be described below with reference to FIG. 1. The electronic-part built-in substrate 10 includes the coreless substrate 11 serving as a multilayer wiring structure, the resin layer 13, the semiconductor chip 14 which is an electronic part, a heat radiating element 16, a Au bump 17, a sealing resin 19, the through-via 21, a solder resist 22, and a diffusion preventing film 23.

The coreless substrate 11 includes laminated insulating layers 26 and 27, the prepreg resin layer 28, a wiring pattern 31, diffusion preventing films 32 and 33, a solder resist 34, and an external connecting terminal 35.

The insulating layer 27 is provided on the insulating layer 26. For example, an epoxy resin may be used as the material of the insulating layers 26 and 27. The prepreg resin layer 28 is provided between the resin layer 13 and the insulating layer 27 and is in contact with the resin layer 13 and the insulating layer 27. The prepreg resin layer 28 is obtained by impregnating a resin into a carbon-fiber fabric or a glass-fiber fabric, or into a carbon fiber or a glass fiber, which are paralleled in a direction. The prepreg resin layer 28 is a lightweight high-stiffness high-strength resin layer functioning as a support plate.

Thus, the prepreg resin layer 28 is provided between the resin layer 13 and the insulating layer 27. Consequently, the strength and the stiffness of the electronic-part built-in substrate 10 can sufficiently be assured to prevent the deformation such as warpage, of the electronic-part built-in substrate 10.

The wiring pattern 31 is provided in the laminated insulating layers 26 and 27 and the prepreg resin layer 28. The wiring pattern 31 includes vias 36, 38, 43, and 44, wi rings 37 and 41, a first connecting pad 46 and a second connecting pad 48.

The via 36 is provided to penetrate through the insulating layer 26. The top portion (an end portion placed at the side of the first main surface of the coreless substrate 11) of the via 36 is connected to the wiring 37. The diffusion preventing film 33 is provided at the bottom portion (an end portion placed at the side of the second main surface of the coreless substrate 11) of the via 36. The wiring 37 is provided on a top surface 26A of the insulating layer 26 by being covered with the insulating layer 27. The wiring 37 is electrically connected to the via 36 on the bottom surface thereof.

The via 38 is provided in the insulating layer 27 placed on the wiring 37. The via 38 electrically connects the wirings 37 and 41. The wiring 41 is provided on a top surface 27A of the insulating layer 27 by being covered with the prepreg resin layer 28. The wiring 41 is electrically connected to the via 38 on the bottom surface thereof.

The via 43 is provided in the prepreg resin layer 28 placed on the wiring 41. The via 43 electrically connects the wiring 41 to the first connecting pad 46. The via 44 is provided in the prepreg resin layer 28 placed on the wiring 41. The via 44 electrically connects the wiring 41 to the second connecting pad 48.

The first connecting pad 46 is provided on the top surface 28A of the prepreg resin layer 28 by being covered with the sealing resin 19. The first connecting pad 46 is electrically connected to the via 43 on the bottom surface thereof. The first connecting pad 46 is electrically connected to the semiconductor chip 14 through the diffusion preventing film 32 and the Au bump 17.

The second connecting pad 48 is provided on the top surface 28A of the prepreg resin layer 28 by being covered with the resin layer 13. The second connecting pad 48 is disposed outside the position at which the first connecting pad 46 is disposed. The second connecting pad 48 is electrically connected to the via 44 and the through-via 21

Incidentally, electrically conductive metals can be used as the material of the wiring pattern 31. For example, Cu may be used as the electrically conductive metal in this case.

The diffusion preventing film 32 is provided on the first connecting pad 46, corresponding to the position at which the Au bump 17 is disposed. The diffusion preventing film 32 is a multilayer film, in which a Ni-layer 51 and an Au-layer 52 are sequentially stacked, on the first connecting pad 46. Additionally, the Au-layer 52 is connected to the Au bump 17.

The diffusionpreventing film 33 is provided at the bottomportion of the via 36. The diffusion preventing film 33 is a multilayer film, in which a Ni-layer 54 and an Au-layer 55 are sequentially stacked, at the bottom portion of the via 36. The Au-layer 55 is connected to the external connecting terminal 35. The solder resist 34 is provided to cover a bottom surface 26B of the insulating layer 26 by exposing the diffusion preventing film 33 therefrom.

The external connecting terminal 35 is provided in the Au-layer 55 of the diffusion preventing film 33 placed at the side of the second main surface of the coreless substrate 11. The external connecting terminal 35 is used to connect the electronic-part built-in substrate 10 to a mount board, such as a mother board. For example, a soldering ball may be used as the external connecting terminal 35.

The resin layer 13 is provided to cover the top surface 28A of the prepreg resin layer 28 that is disposed at the side of the first main surface of the coreless substrate 11. An accommodating portion 57, which is adapted to accommodate the semiconductor chip 14, and a through-hole 59, in which the through-via 21 is provided, are formed in the resin layer 13. The accommodating portion 57 is formed to penetrate through the resin layer 13, corresponding to the semiconductor chip connecting region A. Also, the accommodating portion 57 is configured to have a size larger than that of the outline of the semiconductor chip 14, so that a gap, in which the sealing resin 19 is filled, is formed between a side wall of the accommodating portion 57 and the semiconductor chip 14.

The through-hole 59 is formed to penetrate through the resin layer 13 and to expose the top surface of the second connecting pad 48, corresponding to the through-via formation position B.

The semiconductor chip 14 has an electrode pad 61 and is sealed with the sealing resin 19 while accommodated in the accommodating portion 57. The electrode pad 61 is electrically connected to the first connecting pad 46 through the Au bump 17 and the diffusion preventing film 32. Consequently, the semiconductor chip 14 is electrically connected to the wiring pattern 31 provided in the coreless substrate 11. For example, a memory semiconductor chip and a logic semiconductor chip, which is more likely to generate heat, as compared with the memory semiconductor chip, may be used as the semiconductor chip 14.

Thus, the resin layer 13 having the accommodating portion 57 is provided on the coreless substrate 11. The semiconductor chip 14 is accommodated in the accommodating portion 57 to be electrically connected to the wiring pattern 31. This enables that the semiconductor chip 14 is mounted on the coreless substrate 11 preliminarily determined to be a nondefectiveproduct. Consequently, the yield of the electronic-part built-in substrate 10 can be enhanced.

The heat radiating element 16 is provided on a surface 14B of the semiconductor chip 14, which is opposite to the surface 14B thereof electrically connected to the wiring pattern 31. Additionally, a top surface 16A of the heat radiating element 16 is exposed from the sealing resin 19. The heat radiating element 16 is used to radiate heat generated in the semiconductor chip 14 to the outside of the electronic-part built-in substrate 10. For example, a heat radiating sheet containing silicon gel as a main ingredient may be used as the heat radiating element 16.

Thus, the heat radiating element 16 is provided on the surface 14B of the semiconductor chip 14, which is opposite to a surface 14A thereof electrically connected to the wiring pattern 31. Also, the heat radiating element 16 is exposed from the sealing resin 19. Therefore, a heat radiating path is shortened, as compared with the related electronic-part built-in substrate 200. Consequently, heat generated from the semiconductor chip 14 can be efficiently radiated. Incidentally, it is sufficient to adapt the heat radiating element 16 so that at least the top surface 16A of the heat radiating element 16 is exposed from the sealing resin 19. Or, a part of the top surface 16A and the side surface of the heat radiating element 16 may be exposed from the sealing resin 19. In this case, the heat radiating efficiency of the heat radiating element 16 can be enhanced, as compared with the case of exposing only the top surface 16A of the heat radiating element 16 from the sealing resin 19.

The Au bump 17 is used for connecting the semiconductor chip 14 to the first connecting pad 46 on which the diffusion preventing film 32 is provided, by flip-chip technology. The Au bump 17 electrically connects the electrode pad 17 to the first connecting pad 46.

The sealing resin 19 fills up the accommodating portion 57 to seal the semiconductor chip 14. The sealing resin 19 is disposed to expose at least the top surface 16A of the heat radiating element 16. For example, an underfill resin may be used as the sealing resin 19. For instance, a epoxy-based resin containing glass-filler-dispersed may be used as the underfill resin.

Thus, the semiconductor chip 14 accommodated in the accommodating portion 57 of the resin layer 13 is sealed with the sealing resin 19. Consequently, the position of the semiconductor chip 14 above the coreless substrate 11 can be regulated. Also, the difference in thermal expansion coefficient between the coreless substrate 11 and the semiconductor chip 14 can be reduced.

The through-via 21 is provided in the through-hole 59 that is formed in the resin layer 13. One (the bottom portion) of end portions of the through-via 21 is electrically connected to the second connecting pad 48. The other end portion (the top portion) of the through-via 21 is substantially flush with a top surface 13A of the resin layer 13. For example, an electrically conductive metal may be used as the material of the through-via 21. For instance, Cu may be used as the electrically conductive metal in this case.

Thus, the through-via 21 electrically connected to the second connecting pad 48 is provided in the through-hole 59. Consequently, another substrate (for example, a mount board), a semiconductor device and the like can be connected to the top portion of the through-via 21, which is substantially flush with the top surface 13A of the resin layer 13. Accordingly, the packaging density of the electronic-part built-in substrate 10 can be enhanced.

The solder resist 22 is provided to cover the top surface 13A of the resin layer 13 with the top portion of the through-via 21 exposed.

The diffusion preventing film 23 is provided at the top portion of the through-via 21, which is exposed from the solder resist 22. The diffusion preventing film 23 is a multilayer film in which a Ni-layer 63 and an Au-layer 64 are serially stacked, on the top portion of the through-via 21.

According to the electronic-part built-in substrate of the present embodiment, the resin layer 13 having the accommodating portion 57 adapted to accommodate the semiconductor chip 14 is provided on the coreless substrate 11 having the multilayer wiring structure. Thus, after the coreless substrate 11 is formed, the semiconductor chip 14 can electrically be connected to the wiring pattern 31 in the coreless substrate 11. Consequently, the yield of the electronic-part built-in substrate 10 can be enhanced by connecting the semiconductor chip 14 to the coreless substrate 11 that is preliminarily determined to be a nondefective product.

Additionally, the heat radiating element 16 is provided on the surface 14B of the semiconductor chip 14. Also, the heat radiating element 16 is exposed from the sealing resin 19. Thus, the heat radiating path is shortened, as compared with the related electronic-part built-in substrate 200. Consequently, heat generated from the semiconductor chip 14 can be efficiently radiated.

Furthermore, the through-via 21 electrically connected to the second connecting pad 48 is provided in the through-hole 59 that is formed in the resin layer 13. Thus, another substrate, a semiconductor device and the like can be connected to the top portion of the through-via 21, which is substantially flush with the top surface 13A of the resin layer 13. Consequently, the packaging density of the electronic-part built-in substrate 10 can be enhanced.

Incidentally, in the foregoing description of the present embodiment, the semiconductor chip 14 has been described as an example of the electronic part. However, soldering part, such as a capacitor, may be used instead of the semiconductor chip 14.

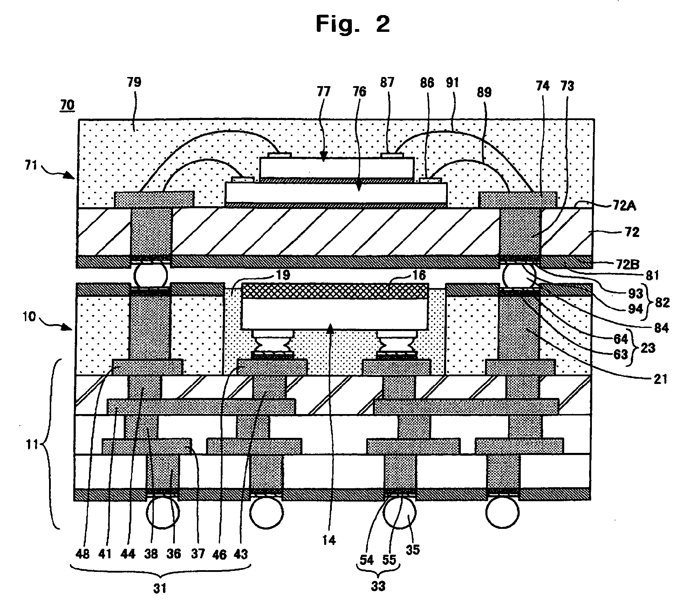

FIG. 2 is a view of an example of an electronic apparatus having the electronic-part built-in substrate according to the present embodiment. In FIG. 2, same reference numeral denotes the same components as those of the electronic-part built-in substrate 10 according to the present embodiment.

Referring to FIG. 2, an electronic apparatus 70 is configured to include the electronic-part built-in substrate 10 and a semiconductor device 71. The semiconductor device 71 includes a substrate 72, a through-via 73, a connecting pad 74, a first semiconductor chip 76, a second semiconductor chip 77, a sealing resin 79, a solder resist 81, a diffusion preventing film 82, and an external connecting terminal 84.

The through-via 73 is provided to penetrate through the substrate 72. An end portion of the through-via 73, which is placed at the side of a top surface 72A of the substrate 72, is electrically connected to the connecting pad 74. Also, the diffusion preventing film 82 is provided at the other end portion of the through-via 73, which is placed at the side of a bottom surface 72B of the substrate 72. The through-via 73 electrically connects the connecting pad 74 to the diffusion preventing film 82.

The connecting pad 74 is provided on the top surface 72A of the substrate 72, corresponding to the position at which the through-via 73 is formed. The connecting pad 74 is electrically connected to the first semiconductor chip 76 and the second semiconductor chip 77 through wires 89 and 91. For example, electrically conductive metals may be used as the materials of the through-via 73 and the connecting pad 74. For instance, Cu may be used as the electrically conductive metal in this case.

The first semiconductor chip 76 has an electrode pad 86. A surface of the first semiconductor chip 76, which is placed at a side on which the electrode pad 86 is not formed, is bonded to the top surface 72A of the substrate 72. The electrode pad 86 of the first semiconductor chip 76 is electrically connected to the connecting pad 74 through the wire 89 (by wire-bonding).

The second semiconductor chip 77 is smaller in outer shape than the first semiconductor chip 76 and has an electrode pad 87. A surface of the second semiconductor chip 77, which is placed at a side on which the electrode pad 87 is not formed, is bonded onto the first semiconductor chip 76. The electrode pad 87 of the second semiconductor chip 77 is electrically connected to the connecting pad 74 through the wire 91 (by wire-bonding).

The sealing resin 79 is provided on the top surface 72A of the substrate 72 and seals the first semiconductor chip 76 and the second semiconductor chip 77, which are wire-bonded to each other, and the wires 89 and 91.

The solder resist 81 is provided to cover a bottom surface 72B of the substrate 72 with the bottom portion of the through-via 73 exposed.

The diffusion preventing film 82 is provided at the bottom portion of the through-via 73 exposed from the solder resist 81. The diffusion preventing film 82 is a multilayer film, in which a Ni-layer 93 and an Au-layer 94 are sequentially stacked at the bottom portion of the through-via 73.

the external connecting terminal 84 is provided on the Au-layer 94 of the diffusion preventing film 82. The external connecting terminal 84 is electrically connected to the first semiconductor chip 76 and the second semiconductor chip 77 through the diffusion preventing film 82, the through-via 73, the connecting pad 74, and the wires 89 and 91. The external connecting terminal 84 is connected to the diffusion preventing film 23 provided on the electronic-part built-in the substrate 10. Consequently, the semiconductor device 71 is electrically connected to the electronic-part built-in the substrate 10.

For example, in a case where a memory semiconductor chip and a logic semiconductor chip, which is more likely than the memory semiconductor chip to generate heat, are electrically connected to the wiring pattern 31 of the coreless substrate 11 in the electronic apparatus 70 of the above configuration, the logic semiconductor chip is placed at a position at which the semiconductor chip 14 is disposed. The memory semiconductor chip is placed at the position of each of the first semiconductor chip 76 and the second semiconductor chip 77. Thus, the memory semiconductor chip and each of the logic semiconductor chips are spaced from each other. Consequently, heat generated by the logic semiconductor chips can be prevented from adversely affecting the memory semiconductor chip. Also, the logic semiconductor chip is placed at a position at which the semiconductor chip 14 is disposed. Thus, heat generated from the logic semiconductor chip can be efficiently radiated by the heat radiating element 16.

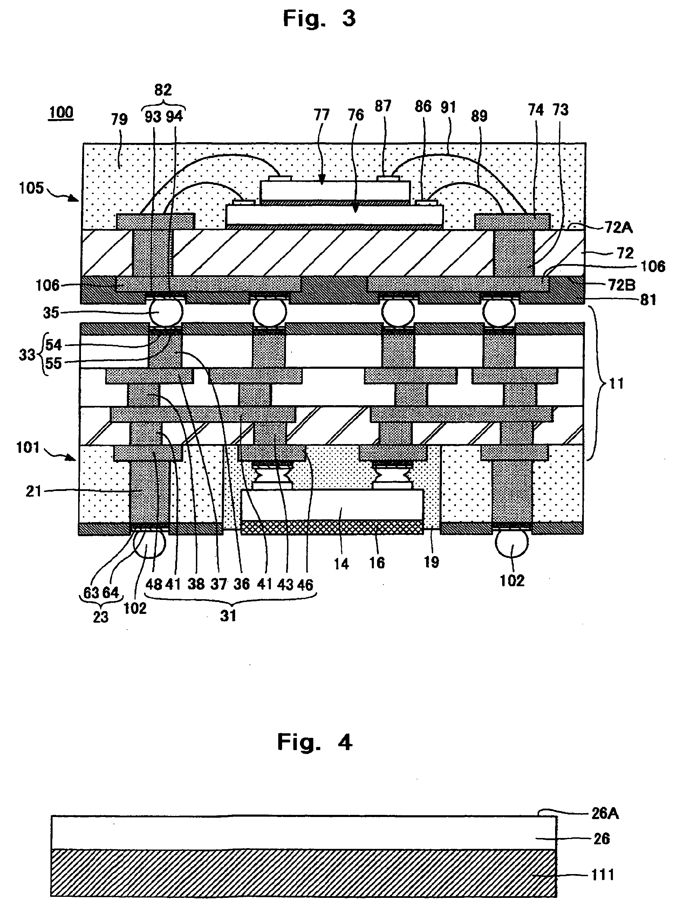

FIG. 3 is a view of another example of the electronic apparatus having the electronic-part built-in substrate according to the present embodiment. In FIG. 3, same reference numeral denotes the same components as those of the electronic-part built-in substrate 70 shown in FIG. 2.

Referring to FIG. 3, an electronic apparatus 100 is configured to have an electronic-part built-in substrate 101 and a semiconductor device 105. The electronic-part built-in substrate 101 is configured similarly to the electronic-part built-in substrate 10, except that an external connecting terminal 102 is provided on a diffusion preventing film 23 of the electronic-part built-in substrate 10. The external connecting terminal 102 is used for connecting the electronic-part built-in substrate 101 to a mount board, such as a mother board. For example, a soldering ball may be used as the external connecting terminal 102.

The semiconductor device 105 is configured similarly to the semiconductor device 71 (see FIG. 2), except that a wiring 106 is provided on the bottom surface 72B of the substrate 72, and that the diffusion preventing film 82 is placed on the wiring 106. The diffusion preventing film 82 is connected to an external connecting terminal 35 provided in the electronic-part built-in substrate 101. Consequently, the semiconductor device 105 is electrically connected to electronic-part built-in substrate 101.

Even the electronic apparatus 100 having such a configuration can obtain advantages similar to those of the electronic apparatus 70.

FIGS. 4 to 33 are views showing a method of manufacturing the electronic-part built-in substrate according to the present embodiment. In FIGS. 4 to 33, same reference numeral denotes the same components as those of the electronic-part built-in substrate 10 according to the present embodiment.

In the beginning, as shown in FIG. 4, a support plate 111 made of an electrically conductive metal is prepared. Then, the insulating layer 26 is formed on the support plate 111. For example, a Cu-plate having a thickness of 400µm or more can be used as the support plate 111. Additionally, the support plate 111 is subjected to surface washing, before the insulating layer 26 is formed thereon. The insulating layer 26 is formed by attaching, for example, a sheet-like epoxy-based resin layer (whose thickness ranges from 30 µm to 40 µm) onto the support plate 111.

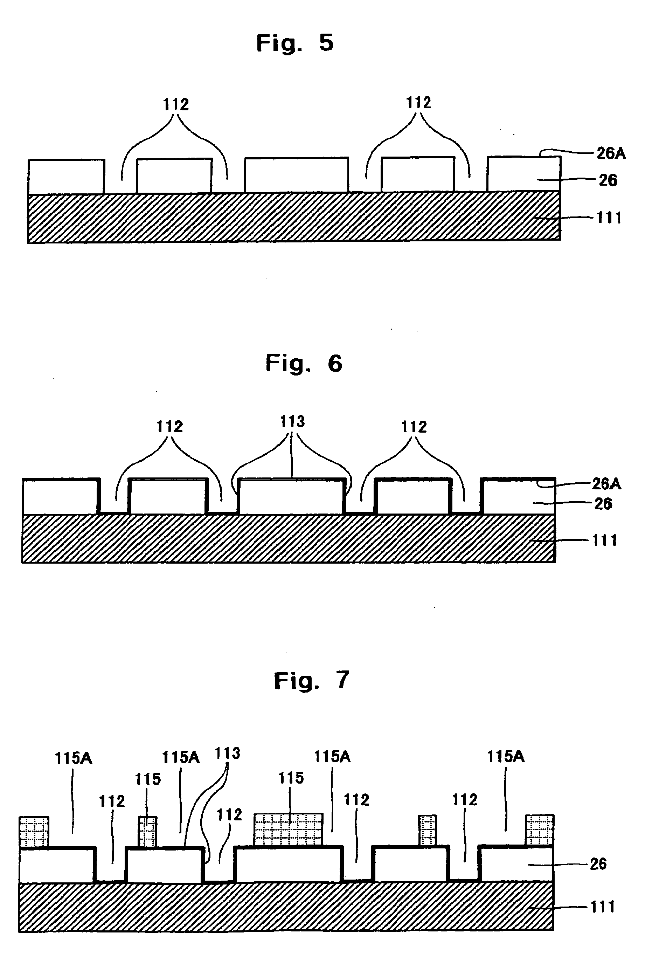

Subsequently, as shown in FIG. 5, each of through-holes 112, from which the support plate 111 is exposed, is formed in the insulating layer 26, corresponding to a position at which the via 36 is formed. The through-holes 112 are formed by, for example, laser-beammachining.

Subsequently, as shown in FIG. 6, a metal layer 113 is formed to cover the top surface 26A of the insulating layer 26 and the through-holes 112. The metal layer 113 is formed by performing electrolytic plating after desmear processing is performed on the insulating layer 26. An electrically conductive metal may be used as the material of the metal layer 113. For example, a Cu-layer (whose thickness is 1µm) can be used as the electrically conductive metal in this case.

Subsequently, as shown in FIG. 7, a dry film resist 115 having opening portions 115A is formed on the structure shown in FIG. 6. The opening portions 115A correspond to the shapes and the formation positions of the wirings 37. For example, PFR-800 AUS410 (manufactured by Taiyo Ink MFG. CO., LTD.) may be used as the dry film resist 115.

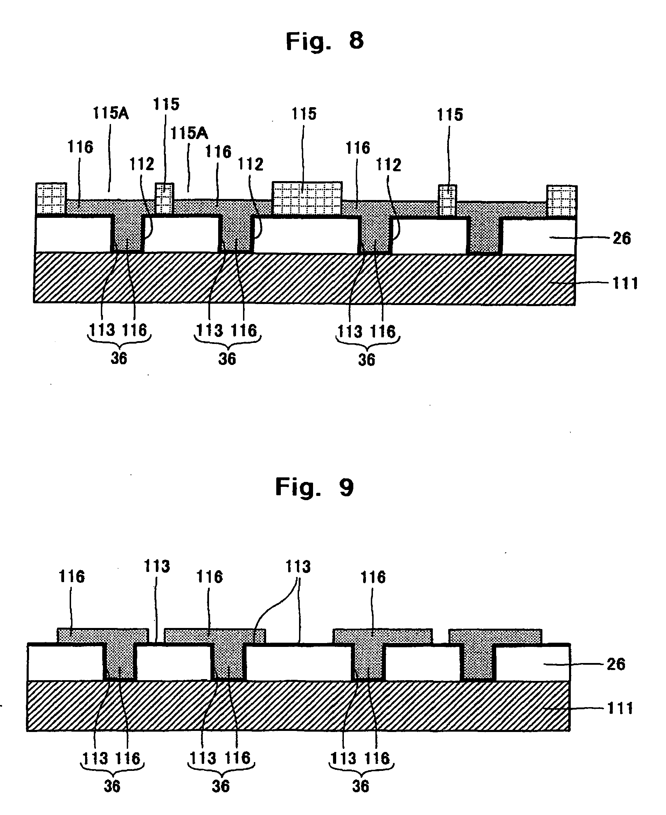

Subsequently, as shown in FIG. 8, the precipitation and growth of an electrically conductive metal 116 are performed by the electrolytic plating using the metal layer 113 as a power feeding layer to fill up through-holes 112 and opening portions 115A. Thus, vias 36, each of which includes the metal layer 113 and the electrically conductive metal 116, are formed in the through-holes 112, respectively. For example, Cu may be used as the electrically conductive metal 116.

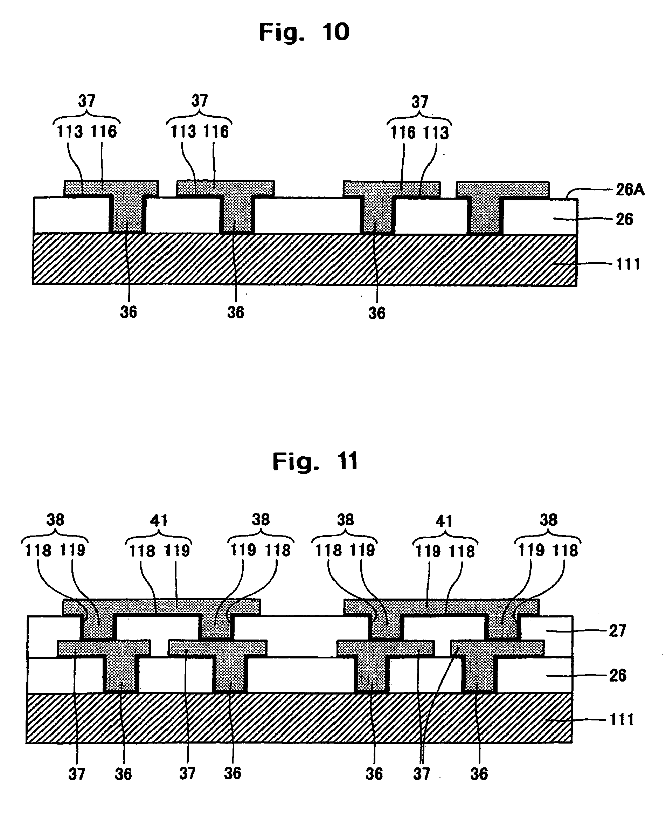

Subsequently, as shown in FIG. 9, the dry film resist 115 is removed. Then, as shown in FIG. 10, the unnecessary metal layer 113, which is not covered with the electrically conductive metal 116, is removed. Consequently, the wirings 37, each of which includes the metal layer 113 and the electrically conductive metal 116, are formed on the top surfaces 26A of the insulating layer 26.

Subsequently, as shown in FIG. 11, the insulating layer 27, vias 38 each of which includes a metal layer 118 and an electrically conductive metal 119, and wirings 41 each of which includes the metal layer 118 and the electrically conductive metal 119 are formed on the structure shown in FIG. 10, by techniques similar to those shown in FIGS. 4 to 10. For example, a sheet-like epoxy-based resin layer (whose thickness ranges from 30 µm to 40 µm) may be used as the insulating layer 27. An electrically conductive metal may be used as the material of the metal layer 118. Practically, for instance, a Cu-layer (whose thickness is 1µm) may be used as the metal layer 118. Also, for example, a Cu-layer may be used as the electrically conductive metal 119.

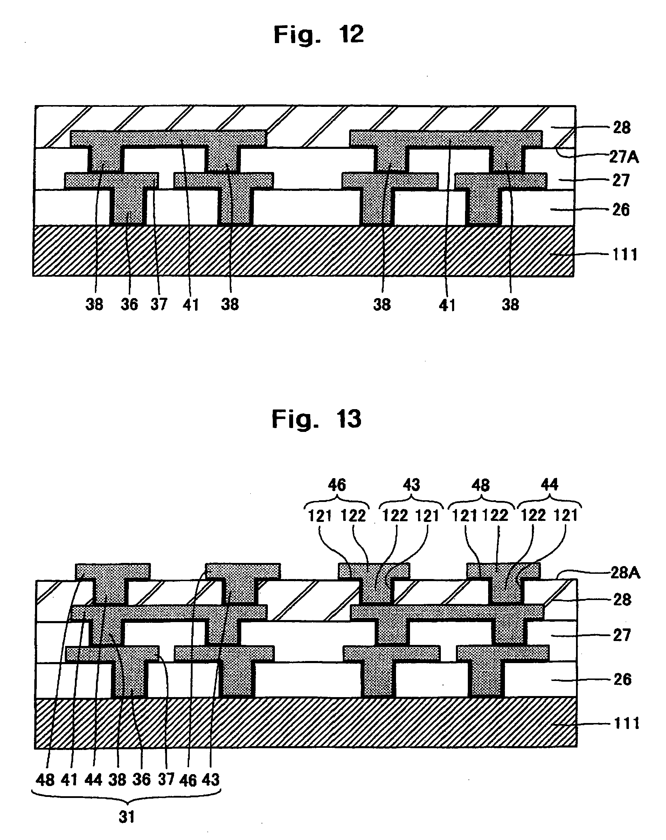

Subsequently, as shown in FIG. 12, the prepreg resin layer 28 is formed to cover the top surface 27A of the insulating layer 27 and the wiring 41. Practically, for example, a sheet-like prepreg resin layer 28 is attached onto the structure shown in FIG. 11. The thickness of the prepreg resin layer 28 may be, for instance, 100µm.

Subsequently, as shown in FIG. 13, the vias 43 and 44, each of which includes a metal layer 121 and an electrically conductive metal 122, are formed in the prepreg resin layer 28 placed on the wiring 41. Also, the first connecting pad 46 and the second connecting pad 48, each of which includes the metal layer 121 and the electrically conductive metal 122, are formed on the top surface 28A of the prepreg resin layer 28. Consequently, the wiring pattern 31 is formed, which includes the vias 36, 38, 43, and 44, the wirings 37, and 41, the first connecting pad 46, and the second connecting pad 48.

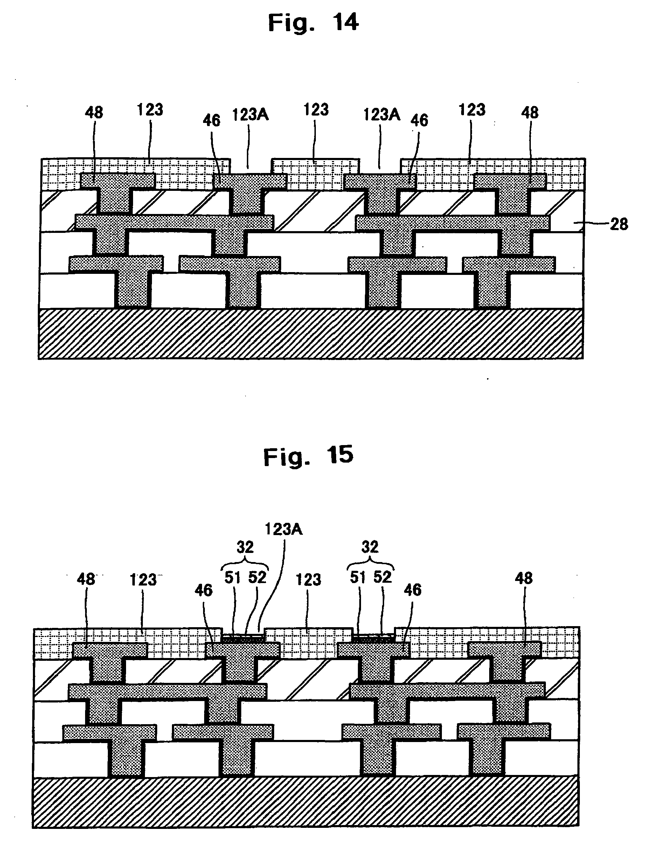

Subsequently, as shown in FIG. 14, a dry film resist 123 having an opening portion 123A is formed on the structure shown in FIG. 13. A dry film resist (a dry film resist into which no plating liquid filtrates), which is resistant to plating liquid (more specifically, plating liquid used when the Ni-layer 51 and the Au-layer 52 are formed), is used as the dry film resist 123. For example, 411Y50 (manufactured by Nichigo-Morton Co., Ltd.) may be used as the film resist 123. The opening portion 123A is formed to expose the top surface of the first connecting pad 46, corresponding to the shape and the formation position of the diffusion preventing film 32.

Subsequently, as shown in FIG. 15, the diffusion preventing film 32 is formed by sequentially stacking the Ni-layer 51 and the Au-layer 52 on the first connecting pad 46, which exposed from the opening portion 123A, through the electrolytic plating method using the metal layer 113 as a power feeding layer.

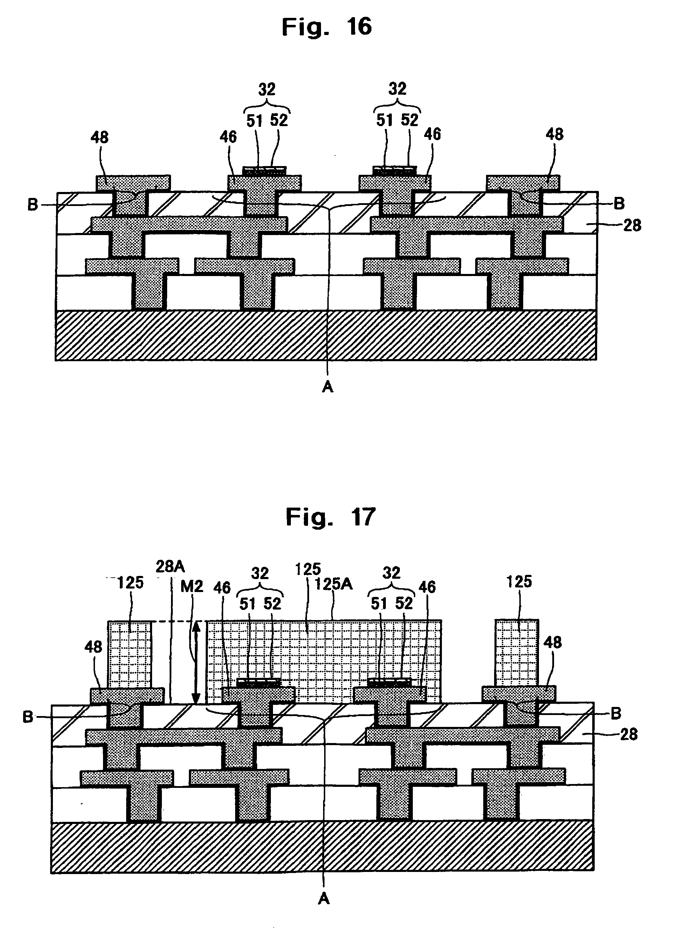

Subsequently, as shown in FIG. 16, the dry film resist 123 is removed. Then, as shown in FIG. 17, a dry film resist 125 is formed on regions corresponding to the semiconductor chip connection region A and to the through-via formation position B on the structure shown in FIG. 16. A dry film resist (a dry film resist into which no plating liquid filtrates), which is resistant to plating liquid (more specifically, plating liquid used when the Ni-layer 51 and the Au-layer 52 are formed), is used as the dry film resist 125. For example, 411Y50 (manufactured by Nichigo-Morton Co., Ltd.) may be used as the film resist 125. The thickness M2 (with respect to the top surface 28A of the prepreg resin layer 28) of the dry film resist 125 may be set at, for example, 100µm.

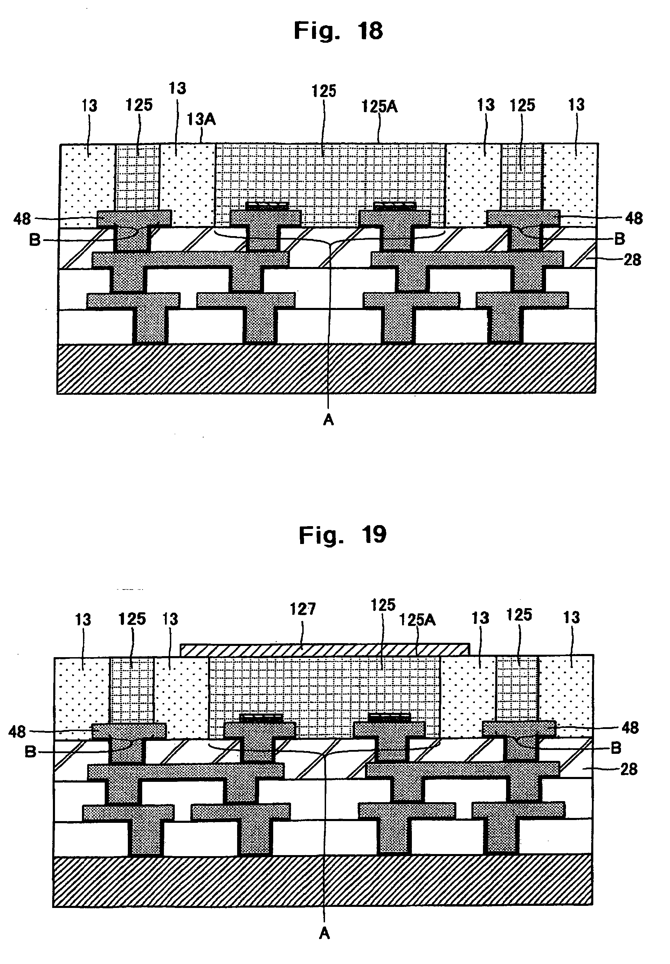

Subsequently, as shown in FIG. 18, the resin layer 13 is formed on a region, which is not covered with the dry film resist 125, on the structure shown in FIG. 17. Then, temporary baking is performed to harden the resin layer 13. The resin layer 13 is formed so that the top surface 13A of the resin layer 13 is substantially flush with the top surface 125A of the fry film resist 125. For example, an epoxy-based resin can be used as the material of the resin layer 13. The resin layer 13 can be formed by, for example, a spin coat method. The temporary curing can be performed under predetermined treatment conditions, for example, at a temperature of 100°C for a curing time of 30minutes.

Subsequently, as shown in FIG. 19, a resist film 127 is formed to cover a top surface 125A of the dry film resist 125 provided on the semiconductor chip connection region A. The resist film 127 is formed by using liquid resist. For example, PSR-4000 AUS703 (manufactured by Taiyo Ink MFG. CO., LTD.) may be used as the liquid resist.

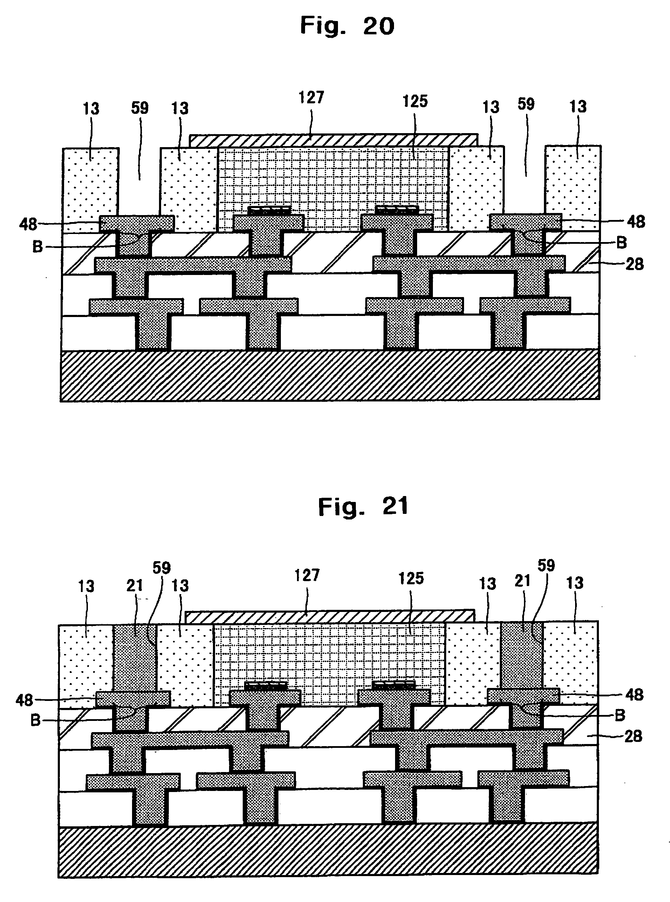

Subsequently, as shown in FIG. 20, the dry film resist 125 formed on the second connecting pad 48 is removed to thereby form the through-hole 59 exposing the second connecting pad 48. The dry film resist 125 is moved by, for example, wet etching using sodium-hydroxide.

Subsequently, as shown in FIG. 21, the precipitation and growth of an electrically conductive metal is performed in the through-hole 59 by the electrolytic plating using the connecting second connecting pad 48 as a power feeding layer. Thus, the through-via 21 is formed. In this case, for example, Cu may be used as the electrically conductive metal.

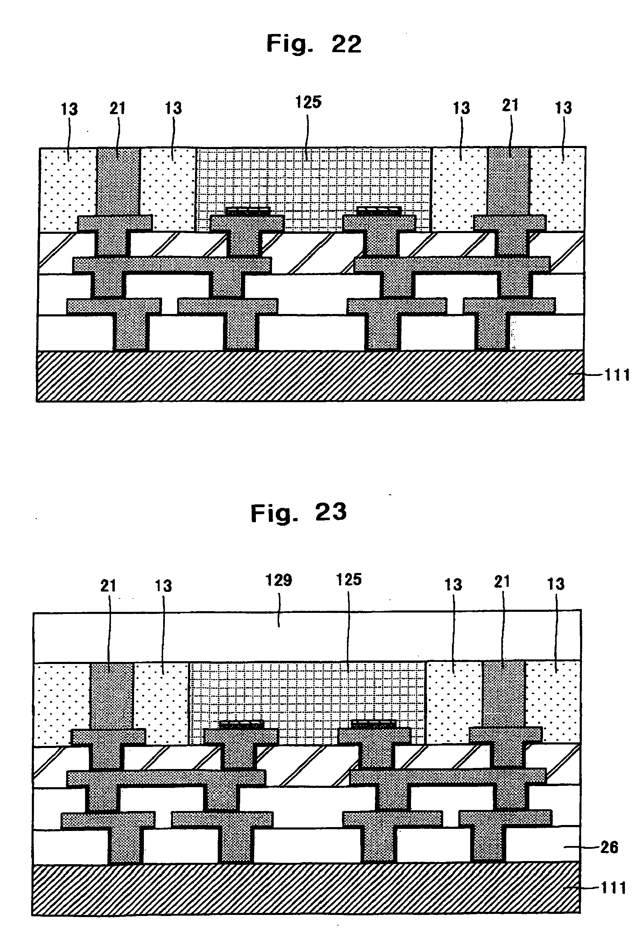

Subsequently, as shown in FIG. 22, the resist film 127 is removed. A method of removing the resist film 127 is, for example, ashing. Then, as shown in FIG. 23, a protection sheet 129 is attached to the structure shown in FIG. 22 to cover the top surface of this structure. The protection sheet 129 is used for preventing the through-via 21 from being etched when the support plate 111 is removed by the wet etching method.

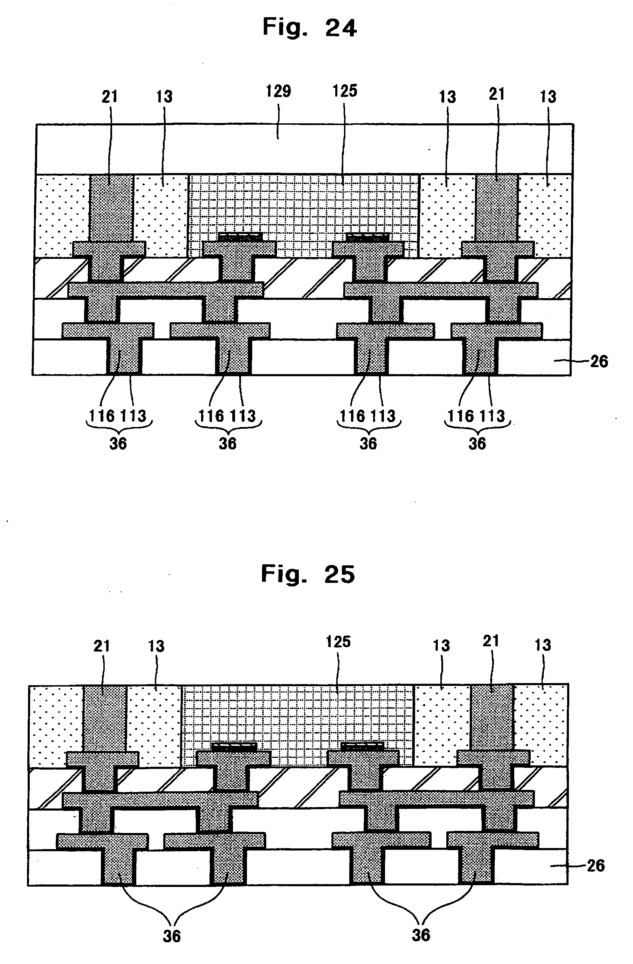

Subsequently, as shown in FIG. 24, the support plate 111 is removed by the wet etching method. Then, the protection sheet 129 is removed, as shown in FIG. 25.

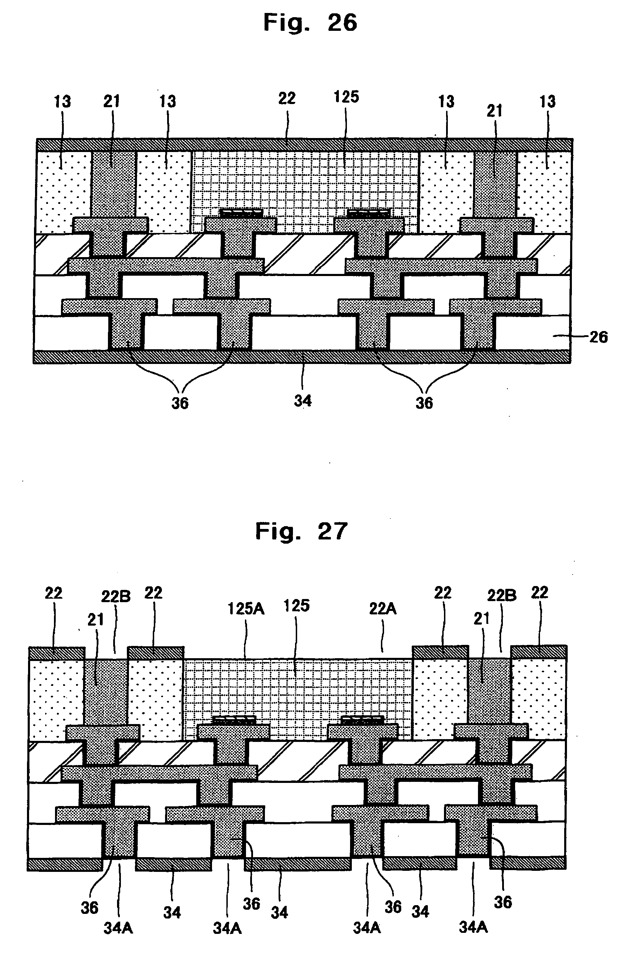

Subsequently, as shown in FIG. 26, the solder resist 22 and the solder resist 34 are formed. The solder resist 22 adapted to cover the top surface of the structure shown in FIG. 25, and the solder resist 34 adapted to cover the bottom surface of the structure shown in FIG. 25. Film-like solder resists may be used as the solder resists 22 and 34. For example, PFR-800 AUS 410 (manufacture by Taiyo Ink MFG. CO., LTD.) may be used as the film-like resist.

Subsequently, as shown in FIG. 27, the exposure and development of the solder resists 22 and 34 are performed to thereby form opening portions 22A and 22B, which penetrate through the solder resist 22, and an opening portion 34A penetrating through the solder resist 34. The opening portion 22A exposes the top surface 125A of the dry film resist 125 formed on the semiconductor chip connection region A. The opening portion 22B exposes the top surface of the through-via 21. Further, the opening portion 34A exposes the bottom surface of the via 36.

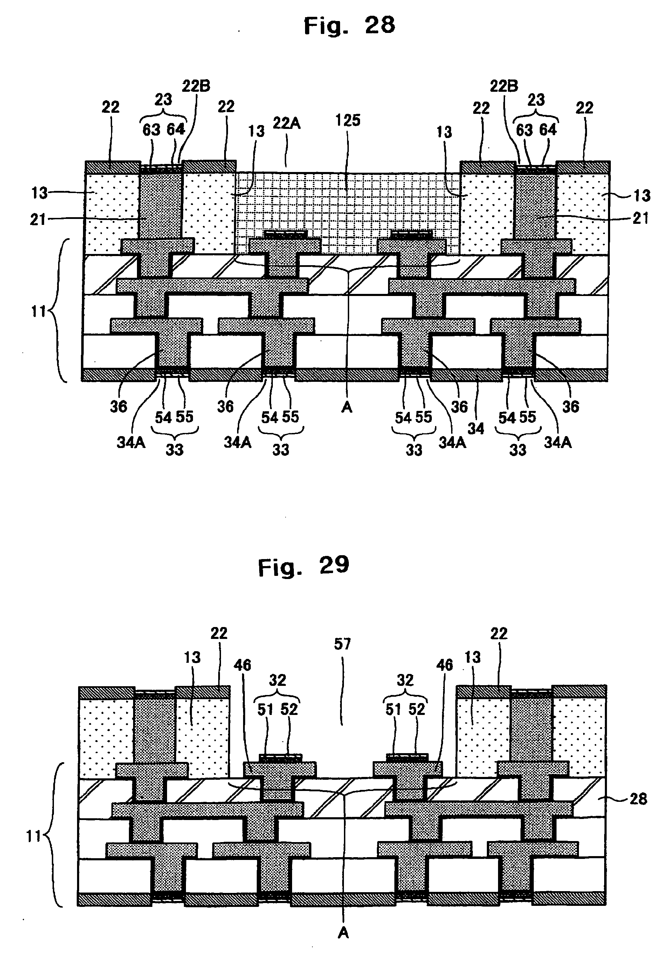

Subsequently, as shown in FIG. 28, the diffusion preventing film 23 and the diffusion preventing film 33 are formed by the electrolytic plating using the through-via 21 and the via 36 as power feeding layers. The diffusion preventing film 23 is obtained by serially stacking the Ni-layer 63 and the Au-layer 64 on the top surface of the through-via 21 exposed in the opening portion 22B, and the diffusion preventing film 33 is obtained by serially stacking the Ni-layer 54 and the Au-layer 55 on the bottom surface of the via 36 exposed in the opening portion 34A.
Thus, the coreless substrate 11 having the multilayer wiring structure is manufactured. Subsequently, the electrical inspection of the coreless substrate 11 determined to be a nondefective product is performed. The coreless substrate 11 determined to be a nondefective product is used in the following steps shown in FIGS. 29 to 33.

Subsequently, as shown in FIG. 29, the dry film resist 125 provided on the semiconductor chip connection region A is removed to form the accommodating portion 57, in which the semiconductor chip 14 is accommodated, on the semiconductor chip connection region A. The accommodating portion 57 penetrates the resin layer 13 and exposes the prepreg resin layer 28, the first connecting pad 46, and the diffusion preventing film 32, corresponding to the semiconductor chip connection region A.

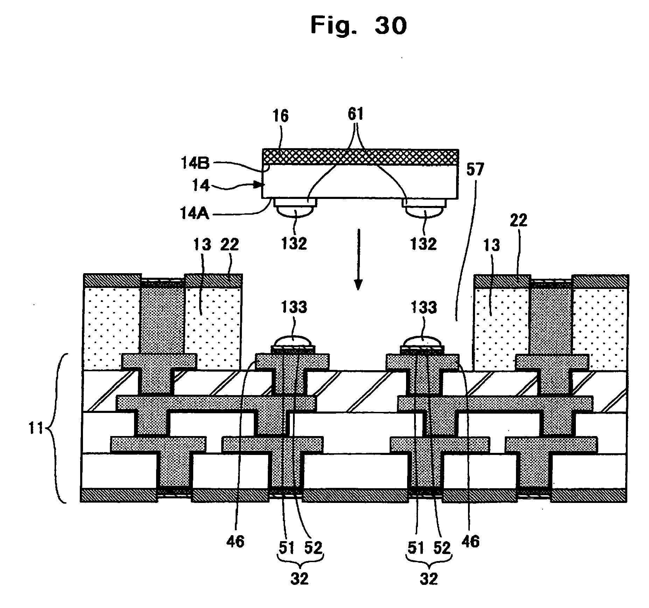

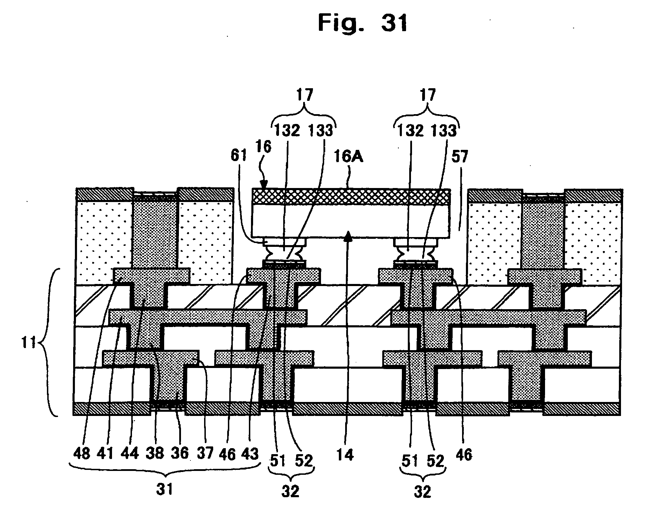

Subsequently, as shown in FIG. 30, the heat radiating element 16 is provided to cover the surface 14B of the semiconductor chip 14, which is opposite to the surface 14A thereof to which the first connecting pad 46 is connected. Then, an Au bump 132 is formed on the bottom surface of the electrode pad 61 of the semiconductor chip 14. Subsequently, an Au bump 133 is formed on the diffusion preventing film 32. The Au bumps 132 and 133 are molten later, and are connected to each other to thereby form the Au bump 17 electrically connecting the semiconductor chip 14 to the diffusion preventing film 32 (see FIG. 31).

Subsequently, as shown in FIG. 31, the Au bumps 132 and 133 are molten and are connected to each other. The Au bump 17 shown in FIG. 31 is obtained as one body by integrating the molten Au bumps 132 and 133. Consequently, the semiconductor chip 14 is electrically connected through the Au bump 17 to the wiring pattern 31 provided in the coreless substrate 11.

Thus, the semiconductor chip 14 is connected to the coreless substrate 11 determined to be a nondefective product. Consequently, the yield of the electronic-part built-in substrate 10 can be enhanced.

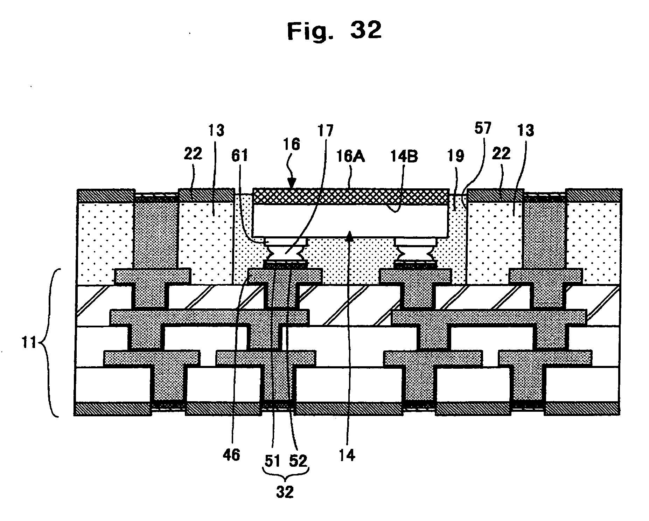

Subsequently, as shown in FIG. 32, the semiconductor chip 14 accommodated in the accommodating portion 57 is sealed with the sealing resin 19. The sealing resin 19 is formed to expose at least the top surface 16A of the heat radiating element 16. For example, an underfill resin may be used as the sealing resin 19. For instance, a epoxy-based resin containing glass-filler-dispersed may be used as the underfill resin.

Thus, the sealing resin 19 is formed to expose at least the top surface 16A of the heat radiating element 16 provided on the surface 14B of the semiconductor chip 14. Consequently, with a simpler configuration than that of the related substrate, heat generated from the electronic part can be efficiently radiated.

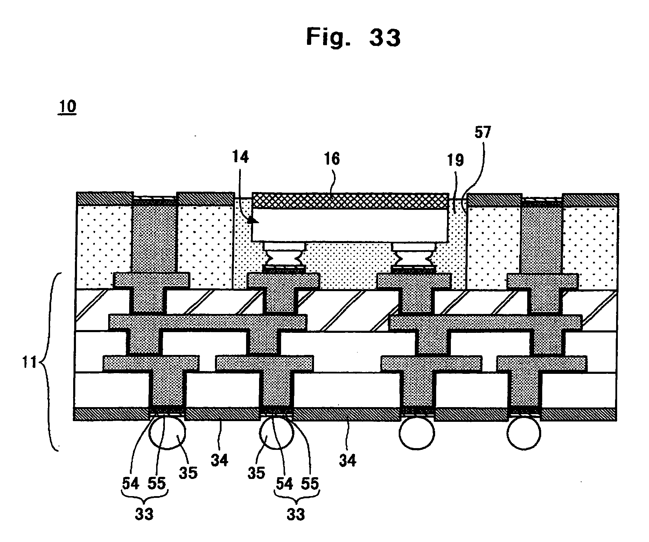

Subsequently, as shown in FIG. 33, an external connecting terminal 35 is formed on the Au-layer 55 of the diffusion preventing film 33, which is placed at the side of the second main surface of the coreless substrate 11. Consequently, the electronic-part built-in substrate 10 is manufactured. For example, a soldering ball may be used as the external connecting terminal 35.

In accordance with the method of manufacturing the electronic-part built-in substrate according to the present embodiment, the resin layer 13 having the accommodating portion 57 adapted to accommodate the semiconductor chip 14 is provided on the coreless substrate 11 determined to be a nondefective product. The wiring pattern 31 provided in the coreless substrate 11 is electrically connected to the semiconductor chip 14. Consequently, the yield of the electronic-part built-in substrate 10 can be enhanced.

Although preferred embodiments of the invention have been described in detail, the invention is not limited to such specific embodiments. Various kinds of modifications and alterations may be made without departing from the spirit or scope of the invention.

Incidentally, although the present embodiment has been described by citing the semiconductor chip 14 as an example of the electronic part, the electronic part except for the semiconductor chip 14,for example, soldering part such as a capacitor, (in this case, it is electrically connected to wiring pattern 31 through a soldering) may be accommodated in the accommodating portion 57.

Also, although the present embodiment has been described by citing the coreless substrate 11 (that is, a substrate enabled to be thinner than a core substrate, because of the absence of a core member) as an example of the multilayer wiring structure, a core substrate having a core member such as a metal plate, may be used instead of the coreless substrate 11.

The invention can be applied to an electronic-part built-in substrate enabled to enhance the yield thereof and to efficiently radiate heat generated from the built-in electronic part.
This application claims foreign priority based on Japanese Patent application No. 2005-313243, filed October 27, 2005, the content of which is incorporated herein by reference in its entirety.

## Claims

1. An electronic-part (14) built-in substrate (10) comprising:
a multilayer wiring structure (11) in which a wiring pattern (31) is formed in laminated insulating layers (26, 27, 28);
an electronic part (14) electrically connected to the wiring pattern (31);
a resin layer (13) which covers a first surface of the multilayer wiring structure (11) and has an accommodating portion (57) which accommodates the electronic-part (14); and
a sealing resin (19) which seals the electronic-part (14) accommodated in the accommodating portion (57).

2. The electronic-part built-in substrate according to claim 1, wherein one of the laminated insulating layers (26, 27, 28), which is in contact with the resin layer, is a prepreg resin layer (28).

3. The electronic-part built-in substrate according to claim 1 or 2, further comprising:
a heat radiating element (16) provided on a surface of the electronic-part (14), which is opposite to a surface thereof electrically connected to the wiring pattern (31), and being exposed from the sealing resin (19).

4. The electronic-part built-in substrate according to one of claims 1 to 3, further comprising:
a through-via (21) electrically connected to the wiring pattern (31) and penetrating through the resin layer (13).

5. The electronic-part built-in substrate according to one of claims 1 to 4, further comprising:
an external connecting terminal (35) provided on a second surface, which is opposite to the first surface of the multilayer wiring structure (11), and being electrically connected to the wiring pattern (31).

6. A method of manufacturing an electronic-part (14) built-in substrate (10), comprising steps of:
forming a multilayer wiring structure (11) in which a wiring pattern (31) is formed in laminated insulating layers (26, 27, 28) ;
forming a resin layer (13) which covers a first surface of the multilayer wiring structure (11) and has an accommodating portion (57); and
providing an electronic part (14) in the accommodating portion (57) of the resin layer (13) and electrically connecting the electronic part (14) to the wiring pattern (31); and
forming a sealing resin (19) which seals the electronic-part (14) accommodated in the accommodating portion (57).

7. The method of manufacturing the electronic-part built-in substrate according to claim 6, further comprising a step of:
forming a through-via (21) which penetrates through the resin layer (13) and is electrically connected to the wiring pattern (31).

8. The method according to claim 6 or 7, further comprising a step of:
providing a heat radiating element (16) on a surface of the electronic-part (14), which is opposite to a surface thereof electrically connected to the wiring pattern (31) and exposed from the sealing resin (19).

9. The method according to one of claims 6 to 8, further comprising a step of:
providing a through-via (21), which is electrically connected to the wiring pattern (31) and which penetrates through the resin layer (13).

10. The method according to one of claims 6 to 9, further comprising a step of:
providing an external connecting terminal (35) on a second surface, which is opposite to the first surface of the multilayer wiring structure (11), and which is electrically connected to the wiring pattern (31).
